# EUROPEAN PATENT APPLICATION

(11) **EP 3 196 567 A1**
(43) Date of publication of application: **26.07.2017**
(21) Application number: 15784071.1
(22) Date of filing: 15.09.2015
(51) Int. Cl.: F24J 2/06, H02S 40/22

(54) **MODULAR SYSTEM FOR HOLOGRAPHIC SOLAR CONCENTRATION INTEGRATED IN URBAN AND ROAD ELEMENTS**

(30) Priority: 15.09.2014 ES 201431329
(71) Applicant: Instituto Holográfico Terrasun, S.L., 41927 Mairena del Aljaraje, Sevilla (ES)
(72) Inventor: RODRIGUÉZ SAN SEGUNDO, Hugo-José, E-41927 Mairena del Aljaraje (Sevilla) (ES); CALO LÓPEZ, Antonio, E-41927 Mairena del Aljaraje (Sevilla) (ES); VILLAMARÍN VILLEGAS, Ayalid Mirlydeth, E-41927 Mairena del Aljaraje (Sevilla) (ES); PÉREZ LÓPEZ, Francisco Javier, E-41927 Mairena del Aljaraje (Sevilla) (ES)
(74) Representative: Pons Ariño, Angel
(86) International application number: PCT/ES2015/070664
(87) International publication number: WO 2016/042186

(57) **Abstract**

The invention relates to holographic concentration solar modules (1), which concentrate the sunlight in photovoltaic solar cells (2), integrated in urban and road elements (3) such as, inter alia, streetlights, bus stops, pedestrian areas on motorways, charging stations, advertising supports and kiosks. The holographic concentration solar modules (1) carry out passive tracking and the design thereof can be adapted to any surface. The efficient capturing of the sunlight in any position is guaranteed by the versatility of the design of the hologram included in the solar module (1). Therefore, according to the invention, in every application a construction element is substituted by a holographic concentration solar module (1). For example, it will form, inter alia, the support of a streetlight, the cover of a bus stop or of a pedestrian area, or the structure of an advertising support. In this way, the solar module (1) constitutes the integration of photovoltaics (BIPV) in urban and road elements. The urban or road element can be autonomous or connected to the grid, in which latter case same can form part of an intelligent grid.

## Description

### Technical sector

The invention is located in the technical sectors of renewable energies, specifically photovoltaic solar energy, energetic efficiency and integration of energy generation in the enveloping of buildings or urban or street elements (BIPV).

### Prior art

The majority of urban and street elements, such as for example street lamps, bus stops, parking meters, motorway toll booths, charging facilities, kiosks and advertising sites, amongst others, need electricity supply to feed the various electric and/or electronic devices thereof, such as lighting, chargers, advertising or informative screens, etc.

Although generally, said elements are connected to the network, it is increasingly more common for them to incorporate an electricity generation system, normally solar photovoltaic, and even a storage system which can allow autonomy. There are a multitude of examples of urban elements with photovoltaic technology incorporated. One example of solar street lamps is provided by Chong and Kong in the patent, WO/2014/126453, Wang and Wang (patent CN 101009071 A), Hao et al. (patent CN 101781939 A), or Freitas et al. (patent US 2014/0080406 A1) can be named as an example of bus stops; solar kiosks are also found, such as for example that proposed by Hixson and Creswell in the patent, US 2013/0033222 A1. Many of these can even be applied to assembly systems for solar modules, as Depaw proposes in the patent EP 2 369 266 A2.

It is also usual for said systems to be able to incorporate intelligent management devices, as Freitas et al. propose in the patent already mentioned.

One element common to all these is the difficulty of combining the urban or street element with the photovoltaic solar module, both aesthetically and technically. Given that for the most part, standard, commercially available, photovoltaic modules are provided, the modules are an element external to the urban or street element. This involves orientations and inclinations which break the aesthetic of the element, even sometimes not allowing the integration thereof in accordance with the urban environments. Although there are architectonic integration solutions, these are generally energetically inefficient and also have a higher cost.

### Description of the invention

The examination of the prior art reports that a significant improvement both in the performance as well as in the aesthetic of the urban and street elements, which generate energy, would be to achieve the architectonic integration of the solar module at low cost.

The present invention proposes to use the versatility of the holographic solar concentration (HSC) modules with the urban and street elements. The HSC modules have, amongst other elements, a hologram and solar cells, and the hologram always directs the light towards these solar cells, whatever the orientation of the module. There exist various versions of HSC modules developed by the applicant, such as for example the 3^{rd} generation in the patent US20080257400 from Mignon and Han, in which a flat HSC module is presented; the 4^{th} generation with a tridimensional module with a concentration factor between 3 and 10x in the patent ESP 201331199 from Calo et al.; or the document "Modular system for solar concentration without tracking by means of combining conventional optics and holographic optical elements (HOES)" from Rodríguez et al. and pending patenting, which presents the 5^{th} generation, a flat HSC module capable of reaching concentration factors from 10x and which separates the optics from the generation part. All these HSC modules can act independently or architectonically integrated, and at a lower cost than that of the conventional flat solar modules, which can even reach 0.25 euros per watt peak.

The versatility of these HSC modules is translated into the form and orientation which they can adopt, since the hologram which they integrate, allows the light from the sun to be captured at a multitude of orientations, without tracking, with high efficiency. Thus, they can be adapted to various forms (straight, curved, round, etc.) and orientations (horizontal, vertical, north, south, east and/or west).

Therefore, the HSC modules can substitute the support of a solar street lamp, as is shown in figure 1, which uses a 4^{th} generation solar module in circular form. One embodiment of the invention for this application is explained further on in the corresponding section. The covers of the toll booths or bus stops can also be substituted, as is observed in figures 2 and 3, or can be included in advertising sites, being able to form part of the stops of the same. One example of this last application is observed in figure 4.

### Description of the drawings

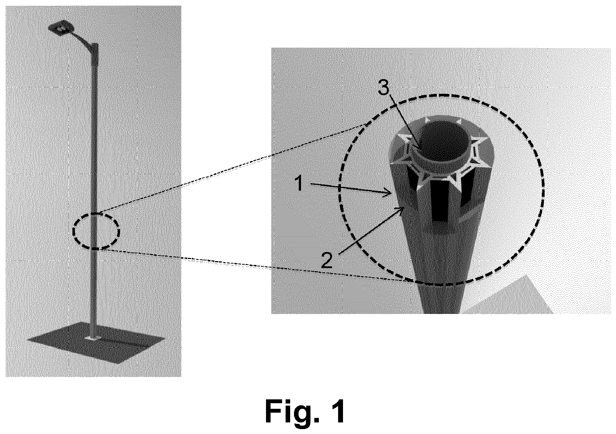

Figure 1. Holographic solar concentration (HSC) module (1) substituting the support of a street lamp or any other urban element (3) which requires a post.

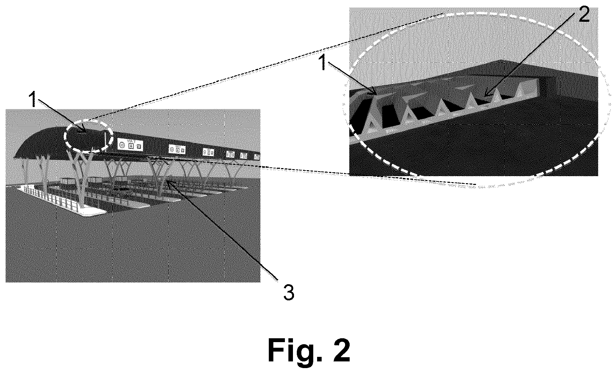

Figure 2. Holographic solar concentration (HSC) module (1) substituting the cover of a toll booth (3).

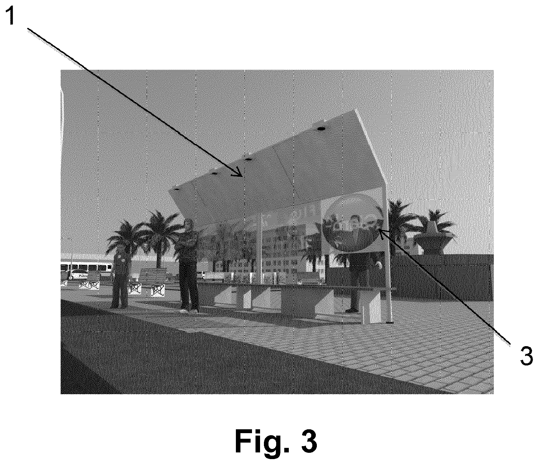

Figure 3. Holographic solar concentration (HSC) module (1) substituting the cover of a bus stop (3).

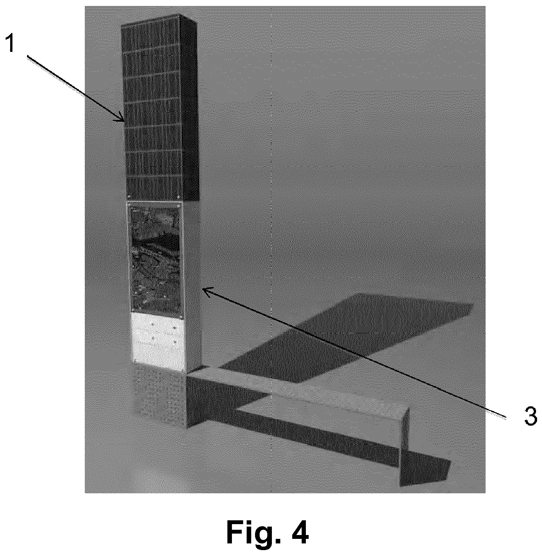

Figure 4. Holographic solar concentration (HSC) module (1) integrated into an advertising site (3).

### Embodiments of the invention

In a preferred, but not exclusive, configuration, the invention is applied to supports of solar street lamps, or any other urban or street element, which requires a post. As is observed in figure 1, the HSC modules in this case are of the 4^{th} generation and form a circle. Each row of solar cells is placed vertically and in different orientations of north to south and east to west. Therefore, the electric interconnection of the HSC module can be made with the different rows in parallel. The street lamp can have one or various sections with a diameter variable in height. With an initial diameter of 300 mm and a height of 9 meters, the potential can be sufficiently covered in order to supply LED lights of 100 watts for 10 hours.

Another non-exclusive configuration relates to substituting the covers of toll booths or bus stops for HSC modules, as can be observed in figures 2 and 3, respectively. In these, the HSC module can be 4^{th} generation and be adapted to the curve of the cover, or 3^{rd} generation, if it is desired flat. The 5^{th} generation modules can be coupled in covers of toll booths which are sufficiently large. In the case of the 4^{th} and 5^{th} generation modules, the solar collection is increased. The 3^{rd} generation can be used if it is desired to transmit visible light below the cover. The hologram is designed according to the final form of the urban or street element, such that whatever the orientation thereof, it directs the light towards the solar cell. The interconnections of the solar cells depend in each case on the different orientations which are presented. Rows of cells are connected in series with similar orientation, and in turn, in parallel with rows of cells in different orientations.

In the case of advertising sites, as is shown in an example in figure 4, the HSC modules are adapted to the form of the support, whether it be vertical, horizontal or inclined. The module most adaptable to these types of urban elements, although not exclusive, is the 4^{th} generation.

HSC modules can be coupled in practically all types of urban and street elements. Other examples are charging facilities, motorway and road signposts, kiosks, etc.

## Claims

1. A modular system for holographic solar concentration which has, amongst other things, holograms and solar cells, **characterized by** being architectonically integrated into urban or street elements, forming part of the structure thereof and being adapted to the forms of the same and the hologram thereof is designed such it captures the solar light in all the positions in which it is integrated into the element and directs it towards the solar cells.

2. The modular system for holographic solar concentration integrated into urban or street elements according to claim 1, **characterized in that** said elements can be street lamps with the module in the support thereof or any other type of element which requires a post, as well as toll booths, kiosks, advertising sites, road or motorway signposts and bus stops and any other type of urban or street amenity.

3. The modular system for holographic solar concentration integrated into urban or street elements according to claims 1 and 2, **characterized in that** the electricity generation can be autonomous, in the case of which the urban or street element is equipped with accumulators or similar such that it can supply electricity in a constant manner.

4. The modular system for holographic solar concentration integrated into urban or street elements according to claims 1 and 2, **characterized in that** the electricity generation can be connected to the network, in the case of which the urban or street element is equipped with current inverters for injecting alternating current to the network.

5. The modular system for holographic solar concentration integrated into urban or street elements according to claims 1, 2 and 4, **characterized in that** the element can incorporate management systems for the electricity production and demand in order to be coupled to intelligent networks.

## Amended claims

### Amended claims under Art. 19.1 PCT

1. Urban or street element, **characterized by** comprising, integrated as part of the structure thereof, a modular system for holographic solar concentration comprising in turn a hologram and solar cells, for generating electricity and powering the element's demand, wherein the hologram is designed such it captures the solar light in various directions and directs it towards the solar cells.

2. Urban or street element, according to claim 1, **characterized in that** said element comprises a post, wherein the modular system is integrated in the post.

3. Urban or street element, according to anyone of claims 1-2, **characterized in that** the element comprises a cover, wherein the modular system is integrated in the cover.

4. Urban or street element, according to claims 1-3, **characterized in that** it additionally comprises accumulators, for providing the modular system with an uninterrupted autonomous supply of the electricity generated by the solar cells.

5. Urban or street element, according to claims 1-3, **characterized in that** it additionally comprises current inverters for injecting in the mains electricity generated by the solar cells.

6. Urban or street element, according to claims 1, 2 and 4, **characterized in that** the element incorporates management systems for managing the electricity generated by the cells and the element's demand, in order to be coupled to intelligent networks.
